(19) Europäisches Patentamt
European Patent Office
Office européen des brevets

(11) **EP 2 609 661 B1**

(12) **EUROPEAN PATENT SPECIFICATION**

(45) Date of publication and mention
of the grant of the patent:
**06.01.2016 Bulletin 2016/01**

(51) Int Cl.:
***H02H 3/00*** (2006.01)

(21) Application number: **11755097.0**

(86) International application number:
**PCT/GB2011/001267**

(22) Date of filing: **24.08.2011**

(87) International publication number:
**WO 2012/025722 (01.03.2012 Gazette 2012/09)**

(54) **APPARATUS FOR USE IN ESTIMATING A FAULT LEVEL IN A NETWORK PROVIDING AN ELECTRICAL POWER SUPPLY TO CONSUMERS**

VORRICHTUNG ZUR BEURTEILUNG EINES FEHLERNIVEAUS IN EINEM NETZWERK ZUR STROMVERSORGUNG VON VERBRAUCHERN

APPAREIL UTILISÉ POUR ÉVALUER UN NIVEAU DE DÉFAUT DANS UN RÉSEAU DISTRIBUANT DE L'ÉLECTRICITÉ À DES CONSOMMATEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.08.2010 GB 201014383**

(43) Date of publication of application:
**03.07.2013 Bulletin 2013/27**

(73) Proprietor: **OUTRAM RESEARCH LIMITED Chichester
West Sussex, PO18 8QQ (GB)**

(72) Inventor: **OUTRAM, John, Douglas
West Sussex P018 8QQ (GB)**

(74) Representative: **Jones, Graham Henry
Graham Jones & Company
77 Beaconsfield Road
Blackheath, London SE3 7LG (GB)**

(56) References cited:
**US-A1- 2010 121 594**

• **Th Boutsika ET AL: "Calculation of the fault level contribution of distributed generation according to IEC standard 60909", , 7 January 2005 (2005-01-07), pages 1-8, XP55014492, Athens Retrieved from the Internet: URL:http://users.ntua.gr/stpapath/Paper_2. 52.pdf [retrieved on 2011-12-12]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to apparatus for use in estimating a fault level in a network providing an electrical power supply to consumers. This invention also relates to a method for use in estimating a fault level in a network providing an electrical power supply to consumers.

Consumers may receive their electrical power supply via one of a plurality of different companies. These different companies are often known as Electricity Utility Companies. In the United Kingdom, there are a number of regions requiring an electrical power supply, with each region being run by a different one of the companies. Similar situations occur in other countries such for example as the United States of America. The different companies are obliged to keep their networks safe against inadvertent faults, for example caused by a tree falling on a power line, or a mechanical digger ripping up an electricity supply cable.

When faults occur, potentially enormous energy levels could be released, like a dam bursting. In order to protect against this, the Utility Companies have "protection circuits" which interrupt the power, i.e. cut it off, immediately a fault occurs. If a protection circuit is sufficiently robust for the inadvertent fault, then there is no problem. However, if the original design of the protection circuit was based on conditions which subsequently change, then there is a danger that the protection circuit is not able to cope with the magnitude of some faults, and therefore the protection circuit will fail to give the required protection for which it was designed.

It is well known that the inadvertent faults cause the creation of excessive currents, and also that these excessive currents that flow create large magnetic fields which can also cause problems. These excessive currents are called "Fault Currents". Sometimes the total "Fault Power" is described. Irrespective of the way in which the excessive currents are described, it is the "Fault Level" that is the critical thing.

In Th Boutsika et al: Calculation of the fault level contribution of distributed generation according to IEC standard 60909", 7 January 2005 (2005-01-07), pages 1 - 8, XP55014492, Athens, there is described an apparatus for use in estimating a fault level in a network providing an electric power supply to consumers, whereby the upsteam impedance is calculated.

It is not possible definitively to measure Fault Level without actually introducing a fault. This is akin to measuring worst case water flow by deliberately bursting a dam. Clearly the Utility Companies do not want deliberately to introduce a fault in their networks in order definitively to measure fault level. Thus the utility companies do their best to computer model their networks, and sometimes they use special pieces of equipment occasionally to put a mini-fault into their network.

About fifteen years ago, the above mentioned problem was the subject of work by a United Kingdom industry-wide body known as the Electricity Association. The Electricity Association produced a device which uses the "natural" disturbances occurring on the network, such for example as the "natural" disturbances occurring due to heavy loads being turned on, or to factories starting up. These "natural" disturbances were used to give clues about the characteristics of the network, and more specifically the network impedance and hence the fault level. If the voltages available are known, and the impedance (resistance) of the network from a power station to the site of a fault is known, then it is possible to calculate the maximum current flow, which would be the fault level. Approximately thirty of the devices were built according to the requirements of the Electricity Association. Each Utility Company was supposed to have two of the devices. The devices work by measuring the changes in voltage and current when the network is disturbed, and then computing the impedance from these changes. This is a relatively easy thing to do for upstream impedance which is upstream of a point of measurement. Critically, the known devices added in another factor which is something that is causing a considerable problem to the Utility Companies at the present time. This extra factor is called "Motor Contribution".

Fault energy generally comes from upstream. However, if motors downstream or upstream of a point of measurement are spinning due to load requirements, and their power source is suddenly removed, then the motors suddenly become electricity generators or dynamos, and they are able to deliver their generated electricity back into the electricity grid of their network. This additional source of electricity is known as the Motor Contribution, and it needs to be included in the overall fault level. This is because the motor contribution boosts the available current in the short term, and can render the protection circuitry under rated just for a critical few tens of milliseconds.

Motors both upstream and downstream of a measurement point may contribute to the fault current. Generally motors upstream of a measurement point are not "visible" to the measurement point since upstream loads do not contribute to the static current passing through the measurement point. However under fault conditions they can briefly contribute as described above, and their dynamic fault contribution can be assessed as part of the overall fault level, generally dominated by conditions upstream. However motors downstream of a measurement point will also contribute and this is more difficult to assess.

The known devices produced by the Electricity Association use a computer model for motors (the Shackshaft model) to estimate possible motor contribution based upon observed current being drawn by the motors. This leaves such estimates vulnerable to the removal of the motors - since it would not be possible to say whether or not the motor contribution ought to be applied or not - if a motor and a similar magnitude resistance load are both applied one after the other such that the motor start-up is observed and its contribution taken into account, and then one load is removed, it is not possible to say with accuracy if it was the motor being isolated, i.e. turned off, or if it was the resistive load. In one case, the motor contribution to the fault current still applies, and in the other case the motor contribution to the fault current does not apply. Multiple motors may exacerbate the uncertainty, because it may not be possible to distinguish between the sequential connection of multiple separate motors, and multiple connections and disconnections of the same motor.

It is an aim of the present invention to reduce the above mentioned problem for both upstream and downstream motor contributions.

Accordingly, in one non-limiting embodiment of the present invention, there is provided apparatus for use in estimating a fault level in a network providing an electric power supply to consumers, which apparatus comprises:

(i) upstream calculator means for calculating upstream impedance which is in the network and upstream of a point of measurement, the upstream impedance being calculated by utilising changes which occur after and consequent upon changes in the electrical power supply due to consumer removal or supply of electricity to the network; and

(ii) downstream calculator means for:

(a) calculating a static downstream impedance which is in the network when the network is in a steady state, which is for use as a reference point, which is downstream of the point of measurement, and which is based on measurements before and/or after the time when the changes in the electrical power supply occur;

(b) measuring the actual downstream impedance at the time when the changes in the electrical power supply occur; and

(c) obtaining the difference between the calculated static downstream impedance and the actual downstream impedance, thereby to obtain a downstream impedance indicative of dynamic downstream motor contribution of electricity to the network.

The apparatus of the invention may be advantageous, not only in dealing with the problem caused by the Motor Contribution, but also in dealing with other non-resistive contributions from other non-resistive components.

Preferably, the apparatus is one in which the downstream calculator means operates in three steps as follows:

(i) Zds is the static downstream impedance calculated from

$$(V1-V2 \text{ mean}/I1 - I2 \text{ mean})$$

(ii)

$$Iprime(t) = I2(t) + (V1 - V2(t))/Zds$$

(iii)

$$Zdown(t) = (V1 - V2(t)) / (I1 - Iprime(t))$$

using ONLY disturbances (steps) for which the voltage and current fall.

It will be appreciated that the above quantities are mathematically complex (complex numbers). The various quantities can be obtained by complex correlation (or by Fourier Transform) techniques over ½ a cycle (or more) of mains voltage, or in the case of three phase applications by direct calculation from simultaneous samples from two or more phases.

Preferably, the static downstream impedance is calculated based on measurements before and after the time when the changes in the electrical power supply occur.

The apparatus of the present invention may include combiner means for combining the upstream impedance with the downstream impedance indicative of the dynamic downstream motor contribution of electricity to the network, thereby to obtain the fault current indicative of the fault level in the network.

The combiner means may operate as follows:

$$Zcombined = Zdown \times Zup / (Zup + Zdown)$$

The apparatus may be one in which the upstream calculator means operates to calculate the upstream impedance utilising changes in voltage and current which occur after and consequent upon the changes in the electrical power supply due to the consumer removal or supply of electricity to the network.

The apparatus may be one which includes a step change detector for detecting step changes in the electrical power supply, and classifier means for receiving (i) inputs from the step change detector, and (ii) voltage and current inputs from the network but not via the step change detector.

Preferably, the apparatus is one in which the upstream calculator means is for calculating upstream static and dynamic impedance.

The present invention also provides a method for estimating a fault level in a network providing an electrical power supply to consumers, which method comprises:

(i) providing upstream calculator means for calculating upstream impedance which is in the network and upstream of a point of measurement, the upstream impedance being calculated by utilising changes which occur after and consequent upon changes in the electrical power supply due to consumer removal or supply of electricity to the network; and

(ii) providing downstream calculator means for:

(a) calculating a static downstream impedance which is in the network when the network is in a steady state, which is for use as a reference point, which is downstream of the point of measurement, and which is based on measurements before and/or after the time when the changes in the electrical power supply occur;

(b) measuring the actual downstream impedance at the time when the changes in the electrical power supply occur; and

(c) obtaining the difference between the calculated static downstream impedance and the actual downstream impedance, thereby to obtain a downstream impedance indicative of dynamic downstream motor contribution of electricity to the network.

In the method of the invention, the downstream calculator means may operate in the above mentioned three steps.

The method of the invention may include providing combiner means for combining the upstream impedance with the downstream impedance indicative of the dynamic downstream motor contribution of electricity to the network, thereby to obtain the fault current indicative of the fault level in the network.

In the method of the invention, the combiner means may operate as mentioned above.

In the method of the invention, the upstream calculator means may also operate as mentioned above.

In the method of the invention, the step change detector may be used for detecting step changes in the electrical power supply, and the classifier means may be used for receiving (i) inputs from the step change detector, and (ii) voltage and current inputs from the network but not via the step change detector. The step detection and classification will normally vary according to the measurement point in the network, network characteristics, etc.

Preferably, in the method of the invention, the upstream calculator means is for calculating upstream static and dynamic impedance.

Embodiments of the invention will now be described solely by way of example and with reference to the accompanying drawings in which:

Figure 1 illustrates the operation of a network which provides an electrical power supply for consumers, and which is liable to receive an inadvertent fault such for example as a tree falling on a power line or a digger ripping up an electricity supply cable, with the result that excessive currents flow, the excessive currents being known as Fault Currents which have a Fault Level; and
Figure 2 shows apparatus for estimating the fault level in the network shown in Figure 1.

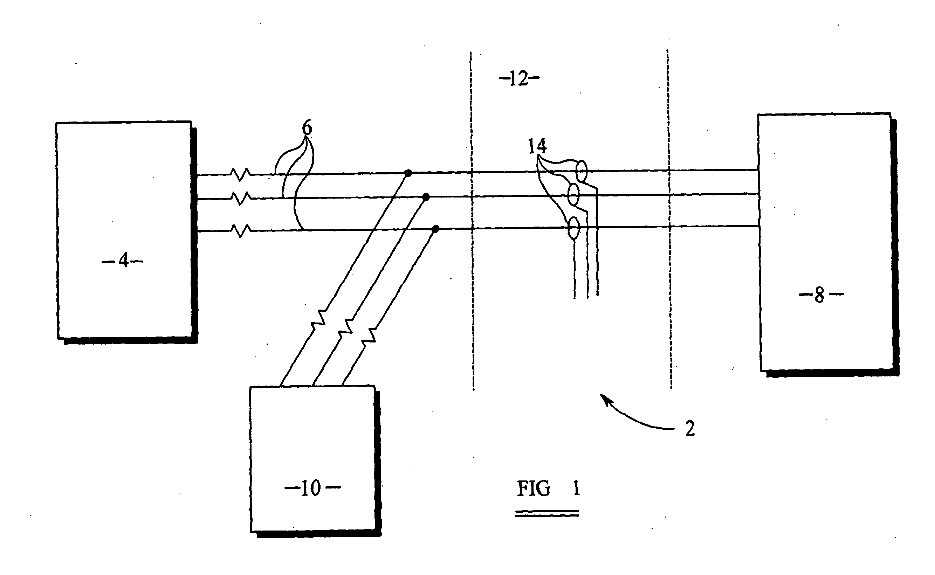

Referring to Figure 1, there is shown a network 2 for providing an electrical power supply to consumers. The network 2 comprises a power station 4 which operates to provide the principle source of electrical power for the network 2. Cables 6 provide the electricity from the power station 4 to a load 8 which may be, for example, required by one or more of towns, factories and motors.

The network 2 includes a dynamic supplementary source of electricity 10. This supplementary source of electricity 10 may include motor contribution and it may be in the form of motors or other electrical generators such as from windfarms or photo-voltaic installations.

The cables 6 have an impedance. In the event of an inadvertent fault such for example as a tree falling on a power line or a digger ripping up an electrical cable, a fault current will occur and it is necessary to know the fault level. Figure 1 shows schematically a measurement point 12 where cables 6 are interrogated at positions 14 in order to measure current and voltage at the measurement point 12. The power station 4 and the supplementary sources of electricity 10 are normally but not always upstream of the measurement point 12. They may also be either side of the measurement point 12, for instance where a windfarm feeds a grid and it is desired to measure the fault level from the windfarm when the wind is blowing and the current is flowing from windfarm to grid. The load 8 which may also include motors is downstream of the measurement point 12. When the load 8 increases, current I rises and voltage V typically falls. Voltage $V_1$ (before the load step due to the load increasing), falls to $V_2$ (t) afterwards, and current $I_1$ (before) rises to $I_2$ (t) after. Both $V_2$ and $I_2$ are functions of time (t) since both $V_2$ and current $I_2$ typically continue to change for a short period after the disturbance step is first seen. V2 mean and I2 mean may be obtained from several cycles occurring after the disturbance step is seen.

Similarly if the output of the power station 4 output varies creating a disturbance, for instance due to tap changing by an Electric Utility Company to manage the network voltage, both Voltage V and current I may rise or fall yielding $V_2$ (t) and $I_2$ (t), i.e. functions of time.

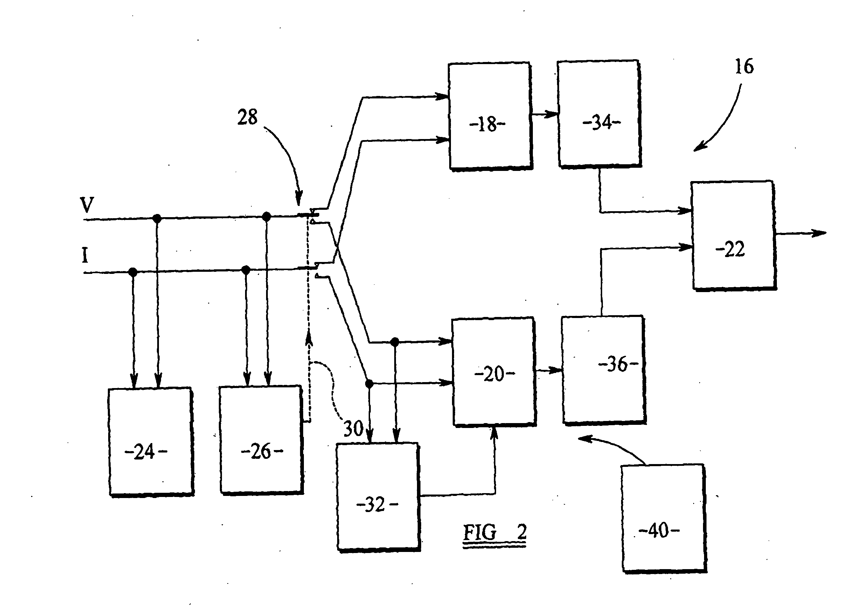

Referring now to Figure 2, there is shown apparatus 16 of the present invention. Thus the apparatus 16 is for estimating a fault level in a network providing an electrical power supply to consumers, for example the network 2. The apparatus 16 comprises upstream calculator means 18, downstream calculator means 20 and combiner means 22. Volts V and current I are shown as passing to a step change detector 24 and a classifier 26. The classifier 26 is able to operate switch means 28 via line 30. With the switch means 28 in an appropriate condition, the voltage V and the current I is able to pass to a Zds static device 32 and to the upstream calculator 18 and the downstream calculator 20. The upstream calculator 18 is in connection with a filter and statistical processor means 34. The downstream calculator 20 is in connection with a post-processor, filter and statistical processor means 36. The means 34 provides Zup(t). The means 36 provides Zdown(t). The combiner means 22 combines Zup(t) and Zdown(t). The entire apparatus 16 may be controlled by control means in the form of a sampling clock 40. The output from the combiner means 22 when combined with the declared nominal or actual voltage for the network is a measure of the fault current which is indicative of the fault level in the network 2.

It will be seen from Figure 2 that the apparatus 16 is such that it comprises:

(i) upstream calculator means for calculating upstream impedance which is in the network and upstream of a point of measurement, the upstream impedance being calculated by utilising changes which occur after and consequent upon changes in the electrical power supply due to consumer removal or supply of electricity to the network;

(ii) downstream calculator means for:

(a) calculating a static downstream impedance which is in the network when the network is in a steady state, which is for use as a reference point, which is downstream of the point of measurement, and which is based on measurements before and/or after the time when the changes in the electrical power supply occur;

(b) measuring the actual downstream impedance at the time when the changes in the electrical power supply occur; and

(c) obtaining the difference between the calculated static downstream impedance and the actual downstream impedance, thereby to obtain a downstream impedance indicative of dynamic downstream motor contribution of electricity to the network; and

(iii) combiner means for combining the upstream impedance with the downstream impedance indicative of the dynamic downstream motor contribution of electricity to the network, thereby to obtain the fault current indicative of the fault level in the network.

The apparatus 16 operates to provide a method for estimating a fault level in a network providing an electrical power supply to consumers. The method comprises providing the above mentioned upstream calculator means, the downstream calculator means, and the combiner means.

The downstream calculator means operates in three steps as follows:

(i) Zds is the static downstream impedance calculated from

$$(V1\text{-}V2 \text{ mean}/I1 - I2 \text{ mean})$$

(ii)

$$Iprime(t) = I2(t) + (V1 - V2(t))/Zds$$

(iii)

$$Zdown(t) = (V1 - V2(t)) / (I1 - Iprime(t))$$

using ONLY disturbances (steps) for which the voltage and current fall.

The combiner means preferably operates as follows:

$$Zcombined = Zdown \times Zup / (Zup + Zdown)$$

The upstream calculator means 18 preferably operates to calculate the upstream impedance utilising changes in voltage and current which occur after and consequent upon the changes in the electrical power supply due to the consumer removal or supply of electricity to the network.

In the apparatus 16, the step change detector 24 operates to detect step changes in the electricity power supply, and the classifier means 26 operates to receive (i) inputs from the step change detector 24, and (ii) voltage and current inputs from the network 2 but not via the step change detector 24.

In a modification of the apparatus 16 as shown in Figure 2, the means 34, 36 can vary or be omitted. When the means 34, 36 are employed, they yield smoothed and ideally noise-free results for each of the instants after a disturbance step for which a user might wish to obtain a fault level. This may be desirable in cases where the statistical processor function is to assess the likely quality of the smoothed result and possible errors in its evaluation. The filtered data from upstream and downstream paths may then be combined and a joint quality figure of merit calculated.

Where the means 34, 36 are employed, they may be likely to want to take account of the weight of each event, perhaps by examination of the size of the voltage and/or current steps at the instant for which the fault level calculation is being made. Thus the size of the event (in terms of voltage and current step magnitude) may be used as a guide to how much weight should be attached to calculated results for that particular instant.

In an alternative embodiment of the invention, the combiner means may be omitted. In this case, the upstream and downstream impedances and hence upstream and downstream fault level contributions are available as separate entities. A user may choose to separate the upstream and downstream fault level contributions entirely, and to view a distribution of the raw unfiltered results of one direction independent of the other, so that the user may then consider whether it is appropriate to simply filter all results from that direction. This may be advantageous because even in one direction only, there exists the possibility of there being more than one "population" or "grouping of results" within the full contribution such for example as that might arise over a period of time during which a major motor contributor has spent part of the time switched off. The set of results developed while the motor is on and potentially making a motor contribution could be substantially different from the set of results developed whilst the motor is off. It may not be appropriate to filter the two different sets of results together, and it may instead be better to view them as two distinctive populations on a single distribution of unfiltered results. Thus, for example, the filter part of the means 34, 36 has significantly less role than as described above with reference to Figures 1 and 2, and the statistical processor part of the means 34, 36 is also different in the two cases. If the data from upstream and downstream are presented as distributions of raw results, it is less clear how these may best be combined, and so combination may be left to the user, or not done at all.

It is to be appreciated that the embodiments of the invention described above with reference to the accompanying drawings have been given by way of example only and that modifications may be effected. Individual components shown in the drawings are not limited to use in their drawings and they may be used in other drawings and in all aspects of the invention.

**Claims**

1. Apparatus for use in estimating a fault level in a network providing an electric power supply to consumers, which apparatus comprises:

   (i) upstream calculator means (18) for calculating upstream impedance which is in the network and upstream of a point of measurement, the upstream impedance being calculated by utilising changes which occur after and consequent upon changes in the electrical power supply due to consumer removal or supply of electricity to the network; and
   (ii) downstream calculator means (20) for:

   (a) calculating a static downstream impedance which is in the network when the network is in a steady state, which is for use as a reference point, which is downstream of the point of measurement, and which is based on measurements before and/or after the time when the changes in the electrical power supply occur;
   (b) measuring the actual downstream impedance at the time when the changes in the electrical power supply occur; and
   (c) obtaining the difference between the calculated static downstream impedance and the actual downstream impedance, thereby to obtain a downstream impedance indicative of dynamic downstream motor contribution of electricity to the network.

2. Apparatus according to claim 1 in which the downstream calculator means operates in three steps as follows:

   (i) Zds is the static downstream impedance calculated from

   $$(V1\text{-}V2 \text{ mean}/I1 - I2 \text{ mean})$$

   (ii)

   $$Iprime(t) = I2(t) + (V1 - V2(t))/Zds$$

   (iii)

   $$Zdown(t) = (V1 - V2(t)) / (I1 - Iprime(t))$$

   using ONLY disturbances (steps) for which the voltage and current fall.

3. Apparatus according to claim 1 or claim 2 and including combiner means for combining the upstream impedance with the downstream impedance indicative of the dynamic downstream motor contribution of electricity to the network, thereby to obtain the fault current indicative of the fault level in the network.

4. Apparatus according to claim 3 in which the combiner means operates as follows:

$$Zcombined = Zdown \times Zup / (Zup + Zdown)$$

5. Apparatus according to any one of the preceding claims in which the upstream calculator means operates to calculate the upstream impedance utilising changes in voltage and current which occur after and consequent upon the changes in the electrical power supply due to the consumer removal or supply of electricity to the network.

6. Apparatus according to any one of the preceding claims and including a step change detector for detecting step changes in the electrical power supply, and classifier means for receiving (i) inputs from the step change detector, and (ii) voltage and current inputs from the network but not via the step change detector.

7. Apparatus according to any one of the preceding claims in which the upstream calculator means is for calculating upstream static and dynamic impedance.

8. A method for use in estimating a fault level in a network providing an electrical power supply to consumers, which method comprises:

   (i) providing upstream calculator means for calculating upstream impedance which is in the network and upstream of a point of measurement, the upstream impedance being calculated by utilising changes which occur after and consequent upon changes in the electrical power supply due to consumer removal or supply of electricity to the network; and
   (ii) providing downstream calculator means for:

      (a) calculating a static downstream impedance which is in the network when the network is in a steady state, which is for use as a reference point, which is downstream of the point of measurement, and which is based on measurements before and/or after the time when the changes in the electrical power supply occur;
      (b) measuring the actual downstream impedance at the time when the changes in the electrical power supply occur; and
      (c) obtaining the difference between the calculated static downstream impedance and the actual downstream impedance, thereby to obtain a downstream impedance indicative of dynamic downstream motor contribution of electricity to the network.

9. A method according to claim 8 in which the downstream calculator means operates in three steps as follows:

   (i) Zds is the static downstream impedance calculated from

$$(V1\text{-}V2\ mean/I1 - I2\ mean)$$

   (ii)

$$Iprime(t) = I2(t) + (V1 - V2(t))/Zds$$

   (iii)

$$Zdown(t) = (V1 - V2(t)) / (I1 - Iprime(t))$$

   using ONLY disturbances (steps) for which the voltage and current fall.

10. A method according to claim 8 or claim 9 and including providing combiner means for combining the upstream impedance with the downstream impedance indicative of the dynamic downstream motor contribution of electricity to the network, thereby to obtain the fault current indicative of the fault level in the network.

11. A method according to claim 10 in which the combiner means operates as follows:

$$\text{Zcombined} = \text{Zdown} \times \text{Zup} / (\text{Zup} + \text{Zdown})$$

12. A method according to any one of claims 8 - 11 in which the upstream calculator means operates to calculate the upstream impedance utilising changes in voltage and current which occur after and consequent upon the changes in the electrical power supply due to the consumer removal or supply of electricity to the network.

13. A method according to any one of claims 8 - 12 and including providing a step change detector for detecting step changes in the electrical power supply, and classifier means for receiving (i) inputs from the step change detector, and (ii) voltage and current inputs from the network but not via the step change detector.

14. A method according to any one of claims 8 - 13 in which the upstream calculator means is for calculating upstream static and dynamic impedance.

**Patentansprüche**

1. Vorrichtung zur Verwendung beim Schätzen eines Fehlerniveaus in einem Netz, das Verbrauchern eine elektrische Stromversorgung bereitstellt, wobei die Vorrichtung Folgendes umfasst:

   (i) ein Upstream-Kalkulatormittel (18) zum Berechnen von Upstream-Impedanz, die sich im Netz und upstream eines Punkts der Messung befindet, wobei die Upstream-Impedanz durch Verwendung von Änderungen berechnet wird, die nach und nachfolgend von Änderungen der elektrischen Stromversorgung aufgrund von Verbraucherentfernung oder Einspeisung von Elektrizität in das Netz auftreten; und
   (ii) ein Downstream-Kalkulatormittel (20) zum

   (a) Berechnen einer statischen Downstream-Impedanz, die sich im Netz befindet, wenn sich das Netz in einem stationären Zustand befindet, die zur Verwendung als Referenzpunkt dient, die sich downstream des Punkts der Messung befindet und die auf Messungen vor und/oder nach dem Zeitpunkt basiert, an dem die Änderungen in der elektrischen Stromversorgung auftreten,
   (b) Messen der tatsächlichen Downstream-Impedanz zu dem Zeitpunkt, an dem die Änderungen in der elektrischen Stromversorgung auftreten; und
   (c) Erhalten der Differenz zwischen der berechneten statischen Downstream-Impedanz und der tatsächlichen Downstream-Impedanz, um dadurch eine Downstream-Impedanz zu erhalten, die einen dynamischen Downstream-Motorbeitrag von Elektrizität zum Netz angibt.

2. Vorrichtung nach Anspruch 1, wobei das Downstream-Kalkulatormittel in drei Schritten folgendermaßen arbeitet:

   (i) Zds ist die statische Downstream-Impedanz, berechnet aus

$$(V1-V2 \text{ Mittel}/I1 - I2 \text{ Mittel})$$

   (ii)

$$\text{Iprime}(t) = I2(t) + (V1 - V2(t))/Zds$$

   (iii)

$$Zdown(t) = (V1 - V(2(t))/(I1 - Iprime(t))$$

unter Verwendung NUR von Störungen (Stufen) bei denen die Spannung und der Strom abfallen.

3. Vorrichtung nach Anspruch 1 oder Anspruch 2 mit einem Kombinierermittel zum Kombinieren der Upstream-Impedanz mit der Downstream-Impedanz, die den dynamischen Downstream-Motorbeitrag von Elektrizität zum Netz angibt, um dadurch den Fehlerstrom zu erhalten, der das Fehlerniveau im Netz angibt.

4. Vorrichtung nach Anspruch 3, wobei das Kombinierermittel folgendermaßen arbeitet:

$$Zcombined = Zdown \times Zup/(Zup + Zdown)$$

5. Vorrichtung nach einem der vorhergehenden Ansprüche, wobei das Upstream-Kalkulatormittel arbeitet, um die Upstream-Impedanz unter Verwendung von Änderungen von Spannung und Strom zu berechnen, die nach und nachfolgend von den Änderungen der elektrischen Stromversorgung aufgrund der Verbraucherentfernung oder Einspeisung von Elektrizität in das Netz auftreten.

6. Vorrichtung nach einem der vorhergehenden Ansprüche und mit einem Stufenänderungsdetektor zum Detektieren von Stufenänderungen der elektrischen Stromversorgung und einem Klassifizierermittel zum Empfangen von (i) Eingaben aus dem Stufenänderungsdetektor und (ii) Spannungs- und Stromeingaben aus dem Netz, aber nicht über den Stufenänderungsdetektor.

7. Vorrichtung nach einem der vorhergehenden Ansprüche, wobei das Upstream-Kalkulatormittel zum Berechnen von statischer und dynamischer Upstream-Impedanz dient.

8. Verfahren zur Verwendung beim Schätzen eines Fehlerniveaus in einem Netz, das Verbrauchern eine elektrische Stromversorgung bereitstellt, wobei das Verfahren Folgendes umfasst:

(i) Bereitstellen eines Upstream-Kalkulatormittels zum Berechnen von Upstream-Impedanz, die sich im Netz und upstream eines Punkts der Messung befindet, wobei die Upstream-Impedanz durch Verwendung von Änderungen berechnet wird, die nach und nachfolgend von Änderungen der elektrischen Stromversorgung aufgrund von Verbraucherentfernung oder Einspeisung von Elektrizität in das Netz auftreten; und
(ii) Bereitstellen eines Downstream-Kalkulatormittels zum

(a) Berechnen einer statischen Downstream-Impedanz, die sich im Netz befindet, wenn sich das Netz in einem stationären Zustand befindet, die zur Verwendung als Referenzpunkt dient, die sich downstream des Punkts der Messung befindet und die auf Messungen vor und/oder nach dem Zeitpunkt basiert, an dem die Änderungen in der elektrischen Stromversorgung auftreten,
(b) Messen der tatsächlichen Downstream-Impedanz zu dem Zeitpunkt, an dem die Änderungen in der elektrischen Stromversorgung auftreten; und
(c) Erhalten der Differenz zwischen der berechneten statischen Downstream-Impedanz und der tatsächlichen Downstream-Impedanz, um dadurch eine Downstream-Impedanz zu erhalten, die einen dynamischen Downstream-Motorbeitrag von Elektrizität zum Netz angibt.

9. Verfahren nach Anspruch 8, wobei das Downstream-Kalkulatormittel in drei Schritten folgendermaßen arbeitet:

(i) Zds ist die statische Downstream-Impedanz, berechnet aus

$$(V1-V2 \text{ Mittel}/I1 - I2 \text{ Mittel})$$

(ii)

$$Iprime(t) = I2(t) + (V1 - V2(t))/Zds$$

(iii)

$$Zdown(t) = (V1 - V(2(t))/(I1 - Iprime(t))$$

unter Verwendung NUR von Störungen (Stufen) bei denen die Spannung und der Strom abfallen.

**10.** Verfahren nach Anspruch 8 oder Anspruch 9 und umfassend Bereitstellen eines Kombinierermittels zum Kombinieren der Upstream-Impedanz mit der Downstream-Impedanz, die den dynamischen Downstream-Motorbeitrag von Elektrizität zum Netz angibt, um dadurch den Fehlerstrom zu erhalten, der das Fehlerniveau im Netz angibt.

**11.** Verfahren nach Anspruch 10, wobei das Kombinierermittel folgendermaßen arbeitet:

$$Zcombined = Zdown \times Zup/(Zup + Zdown)$$

**12.** Verfahren nach einem der Ansprüche 8 - 11, wobei das Upstream-Kalkulatormittel arbeitet, um die Upstream-Impedanz unter Verwendung von Änderungen von Spannung und Strom zu berechnen, die nach und nachfolgend von den Änderungen der elektrischen Stromversorgung aufgrund der Verbraucherentfernung oder Einspeisung von Elektrizität in das Netz auftreten.

**13.** Verfahren nach einem der Ansprüche 8 - 12 und umfassend Bereitstellen eines Stufenänderungsdetektors zum Detektieren von Stufenänderungen der elektrischen Stromversorgung und einem Klassifizierermittel zum Empfangen von (i) Eingaben aus dem Stufenänderungsdetektor und (ii) Spannungs- und Stromeingaben aus dem Netz, aber nicht über den Stufenänderungsdetektor.

**14.** Verfahren nach einem der Ansprüche 8 - 13, wobei das Upstream-Kalkulatormittel zum Berechnen von statischer und dynamischer Upstream-Impedanz dient.

**Revendications**

**1.** Appareil destiné à être utilisé dans l'estimation d'un niveau de défaillance dans un réseau de distribution d'une alimentation électrique à des consommateurs, lequel appareil comprend :

(i) un moyen de calculateur amont (18) pour calculer l'impédance amont qui se trouve dans le réseau et en amont d'un point de mesure, l'impédance amont étant calculée en utilisant les changements qui se produisent après et consécutivement à des changements d'alimentation électrique dus à la suppression de consommateurs ou à la fourniture d'électricité au réseau ; et
(ii) un moyen de calculateur aval (20) pour :

(a) calculer une impédance aval statique qui se trouve dans le réseau quand le réseau est en régime permanent, lequel sert de point de référence, laquelle est en aval du point de mesure, et qui est basée sur des mesures avant et/ou après l'instant auquel se produisent les changements d'alimentation électrique ;
(b) mesurer l'impédance aval effective à l'instant auquel se produisent les changements d'alimentation électrique ; et
(c) obtenir la différence entre l'impédance aval statique calculée et l'impédance aval effective, pour ainsi obtenir une impédance aval indicative d'une contribution dynamique d'électricité par un moteur aval au réseau.

**2.** Appareil selon la revendication 1, dans lequel le moyen de calculateur aval fonctionne en trois stades, comme suit :

(i) Zds est l'impédance aval statique calculée à partir de

$$(V1-V2 \text{ moyenne}/I1-I2 \text{ moyen})$$

(ii)

$$Iprime(t) = I2(t) + (V1 - V2(t))/Zds$$

(iii)

$$Zaval (t) = (V1 - V2(t))/(I1-Iprime(t))$$

en utilisant UNIQUEMENT les perturbations (stades) de défaillance de tension et de courant.

3. Appareil selon la revendication 1 ou la revendication 2, et comportant la combinaison de l'impédance amont et de l'impédance aval indicative de la contribution dynamique d'électricité par un moteur aval au réseau, pour ainsi obtenir le courant de défaillance indicatif du niveau de défaillance dans le réseau.

4. Appareil selon la revendication 3, dans lequel le moyen de combinaison fonctionne comme suit :

$$Zcombinée = Zaval \times Zamont/(Zamont + Zaval)$$

5. Appareil selon l'une quelconque des revendications précédentes, dans lequel le moyen de calculateur amont a pour fonction de calculer l'impédance amont en utilisant les changements de tension et de courant qui se produisent après et consécutivement aux changements d'alimentation électrique dus à la suppression de consommateurs ou à la fourniture d'électricité au réseau.

6. Appareil selon l'une quelconque des revendications précédentes et comportant un détecteur de changement de stade pour détecter des changements de stade dans l'alimentation électrique, et un moyen de classification pour recevoir (i) des entrées depuis le détecteur de changement de stade, et (ii) des entrées de tension et de courant depuis le réseau mais pas via le détecteur de changement de stade.

7. Appareil selon l'une quelconque des revendications précédentes, dans lequel le moyen de calculateur amont a pour fonction de calculer l'impédance statique et dynamique amont.

8. Procédé destiné à être utilisé dans l'estimation d'un niveau de défaillance dans un réseau de distribution d'alimentation électrique à des consommateurs, lequel procédé comprenant :

(i) la fourniture d'un moyen de calculateur amont pour calculer l'impédance amont qui se trouve dans le réseau et en amont d'un point de mesure, l'impédance amont étant calculée en utilisant des changements qui se produisent après et consécutivement à des changements d'alimentation électrique dus à la suppression de consommateurs ou la fourniture d'électricité au réseau ; et
(ii) la fourniture d'un moyen de calculateur aval pour :

(a) calculer une impédance aval statique qui se trouve dans le réseau quand le réseau est en régime permanent, lequel sert de point de référence, laquelle est en aval du point de mesure, et qui est basée sur des mesures avant et/ou après l'instant auquel se produisent les changements d'alimentation électrique ;
(b) mesurer l'impédance aval effective à l'instant auquel se produisent les changements d'alimentation électrique ; et
(c) obtenir la différence entre l'impédance aval statique calculée et l'impédance aval effective, pour ainsi obtenir une impédance aval indicative d'une contribution dynamique d'électricité par un moteur aval au réseau.

**9.** Procédé selon la revendication 8, dans lequel le moyen de calculateur aval fonctionne en trois stades, comme suit :

(i) Zds est l'impédance aval statique calculée à partir de

$$\text{(V1-V2 moyenne/I1-I2 moyen)}$$

(ii)

$$\text{Iprime(t) = I2(t) + (V1 - V2(t))/Zds}$$

(iii)

$$\text{Zaval (t) = (V1 - V2(t))/(I1-Iprime(t))}$$

en utilisant UNIQUEMENT les perturbations (stades) de défaillance de tension et de courant.

**10.** Procédé selon la revendication 8 ou la revendication 9, et comportant la fourniture d'un moyen de combinaison pour combiner l'impédance amont et l'impédance aval indicative de la contribution dynamique d'électricité par un moteur aval au réseau, pour ainsi obtenir le courant de défaillance indicatif du niveau de défaillance dans le réseau.

**11.** Procédé selon la revendication 10, dans lequel le moyen de combinaison fonctionne comme suit :

$$\text{Zcombinée = Zaval x Zamont/(Zamont + Zaval)}$$

**12.** Procédé selon l'une quelconque des revendications 8 à 11, dans lequel le moyen de calculateur amont a pour fonction de calculer l'impédance amont en utilisant les changements de tension et de courant qui se produisent après et consécutivement aux changements d'alimentation électrique dus à la suppression de consommateurs ou à la fourniture d'électricité au réseau.

**13.** Procédé selon l'une quelconque des revendications 8 à 12 et comportant la fourniture d'un détecteur de changement de stade pour détecter des changements de stade dans l'alimentation électrique, et d'un moyen de classification pour recevoir (i) des entrées depuis le détecteur de changement de stade, et (ii) des entrées de tension et de courant depuis le réseau mais pas via le détecteur de changement de stade.

**14.** Procédé selon l'une quelconque des revendications 8 à 13 , dans lequel le moyen de calculateur amont a pour fonction de calculer l'impédance statique et dynamique amont.

FIG 1

EP 2 609 661 B1

FIG 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TH BOUTSIKA et al.** *Calculation of the fault level contribution of distributed generation according to IEC standard 60909,* 07 January 2005, 1-8